Europäisches Patentamt

**European Patent Office**

Office européen des brevets

(19)

(11) Numéro de publication: **0 038 754 B1**

(12) # FASCICULE DE BREVET EUROPEEN

(45) Date de publication du fascicule du brevet:
**24.10.84**

(51) Int. Cl.³: **G 11 C 19/08**

(21) Numéro de dépôt: **81400616.9**

(22) Date de dépôt: **17.04.81**

(54) **Mémoire à bulles magnétiques.**

(30) Priorité: **18.04.80 FR 8008765**

(43) Date de publication de la demande:
**28.10.81 Bulletin 81/43**

(45) Mention de la délivrance du brevet:
**24.10.84 Bulletin 84/43**

(84) Etats contractants désignés:
**DE GB IT NL**

(56) Documents cités:
**EP - A - 0 037 900**
**WO - A - 79/00360**
**US - A - 3 916 396**

**IEEE Transactions on Magnetics, Vol. MAG 13, no. 6,**
**November 77, Pages 1744-1764**

(73) Titulaire: **COMMISSARIAT A L'ENERGIE ATOMIQUE**
**Etablissement de Caractère Scientifique Technique et**
**Industriel, B.P. 510, F-75752 Paris Cedex 15 (FR)**

(72) Inventeur: **Boshra-Riad, Mokhtar, 12, Rue Aly Elshiemy,**
**Alharam Giza (EG)**
Inventeur: **Fedeli, Jean-Marc, Beauséjour Le Fontanil**
**Cornillon, F-38120 Saint Egreve (FR)**
Inventeur: **Jouve, Hubert, 8, Domaine des Plantées,**
**F-38330 Biviers (FR)**
Inventeur: **Mauduit, Daniel, Charnècles, F-38140 Rives**
**Sur Fure (FR)**

(74) Mandataire: **Mongrédien, André et al, c/o**
**BREVATOME 25, rue de Ponthieu, F-75008 Paris (FR)**

## Description

La présente invention concerne une mémoire à bulles magnétiques. Elle s'applique à la mémorisation d'informations binaires ou bits, matérialisées sous la forme de domaines magnétiques isolés, qualifiés de «bulles»; ces domaines présentent une aimantation inverse de celle du reste du matériau magnétique qui constitue la couche dans laquelle ils sont formés.

Chaque bulle peut être déplacée par une force et le mouvement peut s'effectuer librement dans n'importe quelle direction, dans le plan de la couche magnétique. La couche magnétique est un grenat magnétique et les bulles sont formées dans cette couche en lui appliquant un champ magnétique continu perpendiculaire au plan de la couche. Ce champ est produit dans la pratique, par un aimant permanent; il assure la non volatilité des informations contenues dans la mémoire.

La couche de grenat magnétique dans laquelle sont formées les bulles, est généralement supportée par un grenat monocristallin amagnétique.

Il est connu de déplacer les bulles grâce à l'application d'un champ magnétique tournant dont le rôle est de créer des pôles sur des motifs en permalloy par exemple, qui présentent la forme de barres en T, en chevrons, ou la forme de demi-disques. On réalise ainsi des registres à décalage dans lesquels l'information binaire est représentée par la présence «1» ou l'absence «0» d'une bulle. En plus de ces motifs en permalloy, on sait qu'il est nécessaire d'utiliser des conducteurs électriques pour réaliser sur la puce de mémoire à bulles, des fonctions d'écriture, d'enregistrement de l'information, de lecture non destructive, de transferts de registre à registre et d'effacement. L'effacement est réalisé bit par bit, par destruction sélective des bulles, ou globalement. Cet effacement est obtenu très simplement en augmentant la valeur du champ magnétique continu, au-delà de la valeur maximum permise pour l'enregistrement.

Pour déplacer les bulles dans la couche de grenat magnétique, on sait actuellement utiliser deux techniques: les bulles peuvent être déplacées soit par courant électrique, soit par champ magnétique.

Les principaux types de mémoire à bulles magnétiques, connus, sont les suivants:

– les mémoires constituées par un registre bouclé simple, qui peuvent être qualifiée de mémoires à organisation série, dans lesquelles apparaît un seul registre à décalage, bouclé et très long. Ce registre est muni d'une seule station d'accès capable d'accéder à un seul bit à la fois. Ce type de mémoire, bien que très simple, nécessite un temps d'accès très long, ne permettant aucun accès aléatoire; il nécessite une fabrication parfaite. En effet, tout défaut pourrait produire une coupure dans la chaîne de bulles qui représente les informations contenues dans le registre;

– les mémoires présentant une organisation en «registres mineurs– registre majeur». Ces mémoires comprennent un ensemble de boucles d'enregistrement appelées «registres mineurs», qui permettent d'enregistrer les informations. Une autre boucle appelée «registre majeur», comporte la station d'accès. Les registres mineurs sont disposés longitudinalement, les uns à côté des autres et le registre majeur est orienté transversalement; les bulles magnétiques contenues dans les registres mineurs peuvent être transférées dans le registre majeur par l'intermédiaire de portes de transfert. Ces portes compliquent la structure et la fabrication de la mémoire; de plus, le temps d'accès est important puisque les bulles magnétiques peuvent parcourir toute la longueur du registre majeur avant de parvenir à la station d'accès, puis, suivre un chemin équivalent pour leur retour dans les registres mineurs. Enfin, le décalage dans les registres mineurs est unidirectionnel, par suite de contraintes de synchronisation dans la propagation des bulles entre les registres mineurs et le registre majeur;

– les mémoires à bulles qui comprennent une série de registres à décalage ou registres mineurs, orientés longitudinalement, et un registre majeur disposé transversalement. Dans ce type de mémoire, le registre majeur est qualifié de contour d'accès et il est incorporé aux registres mineurs qui participent ainsi par au moins deux bits au contour d'accès. Dans ce cas, l'influence du contour d'accès peut être néfaste pour des bulles voisines. En effet, en créant des gradients de champ magnétique nécessaire au déplacement des bulles sur ce contour d'accès, il est possible qu'apparaisse un affaiblissement des bulles proches dans la zone de mémoire considérée.

Pour ces deux derniers types de mémoires qui utilisent généralement des registres mineurs constitués par des motifs en permalloy présentant la forme de T, de chevrons, ou de demi-disques, il est pratiquement impossible d'assurer un transfert des bulles d'un registre mineur vers un autre registre mineur. Avec les motifs en demi-disques, la répartition des potentiels magnétiques le long du registre majeur n'est pas homogène et lors du transfert de bulles, le long de ce registre majeur, des discontinuités de champ apparaissent et peuvent provoquer des affaiblissements des bulles.

Les mémoires citées plus haut sont par exemple celles qui sont décrites dans le brevet US-A-3 916 396 et dans la revue IEEE Transactions ou Magnetics, vol. Mag. 13, no 6 – Article de Y.S. Lin et al.; Contiguous Disk bubble Domain Devices, pages 1744–1764.

Enfin, l'homme de métier a souvent considéré qu'il serait très intéressant de n'avoir qu'un seul point d'accès entre un registre mineur et un registre majeur. C'est le cas par exemple de la mémoire décrite dans la demande de brevet EP-A-37 900 publiée le 21.10.81. Cette mémoire comporte une série de registres à décalage orientés longitudinalement et au moins un registre orienté transversalement constitué de points mémoires desdits registres à décalage que l'on peut qualifier de contour d'accès, des moyens pour produire un décalage de bulles dans les registres longitudinaux par application d'un champ magnétique tournant, lesdits registres étant constitués par des motifs définis par implantation ionique dans une couche magnétique, le contour d'accès transversal présentant à chaque extrémité des registres un seul point d'accès, ledit contour d'accès comportant des moyens d'accès par courant électrique, le parcours des bulles provoqué par ces moyens d'accès étant commandé par des impulsions ($I_1$, $I_2$) de courant de double polarité, la mémoire comprenant en outre des moyens pour arrêter les moyens d'application du champ tournant pendant le fonctionnement des moyens d'accès.

Dans cette mémoire, les moyens d'accès par courant sont constitués par des conducteurs de forme compliquée, présentant des méandres difficiles à réaliser.

L'invention a pour but de remédier aux inconvénients des mémoires connues et notamment de réaliser une mémoire à bulles dans laquelle les informations contenues dans des registres mineurs, à décalage, orientés longitudinalement, peuvent être transmises bit par bit à un contour d'accès orienté transversalement, grâce à la présence d'un seul point de tangence entre l'extrémité de chaque registre à décalage et le contour d'accès tout en évitant toute contrainte de longueur des registres à décalage et des registres d'accès. Elle permet également d'assurer rapidement l'accès à deux adresses consécutives d'un même registre à décalage, par un seul décalage dans ce registre. Enfin, elle évite d'avoir à utiliser des portes d'accès dont la résistance élevée produit une dissipation importante, dans les mémoires connues. L'invention permet également de fabriquer ces mémoires selon une technologie plane, sans utilisation de motifs en demi-lunes, en T ou en chevrons, en méandres, et sans utilisation de motifs protubérants puisqu'il n'est plus nécessaire de prévoir des portes entre les registres à décalage et le contour d'accès. Elle évite enfin d'avoir à tenir compte de décalages de phase entre les impulsions qui permettent le transfert des bulles dans le contour d'accès, et le champ tournant qui permet les décalages de ces bulles dans les registres à décalage.

L'invention a pour objet une mémoire à bulles magnétiques comprenant une série de registres à décalage orientés longitudinalement et au moins un registre orienté transversalement constitué de points mémoires desdits registres à décalage et qualifié de contour d'accès, des moyens pour produire un décalage de bulles dans les registres longitudinaux, par application d'un champ magnétique tournant, les registres longitudinaux étant constitués par des motifs définis par implantation ionique dans une couche d'un grenat magnétique et le contour d'accès transversal présentant à chaque extrémité d'accès de chacun des registres un seul point d'accès, le contour d'accès comprenant des moyens d'accès par courant électrique, le parcours des bulles provoqué par ces moyens d'accès étant commandé par des impulsions ($I_1$, $I_2$) de courant de double polarité, la mémoire comprenant en outre des moyens pour arrêter les moyens d'application du champ magnétique tournant, pendant le fonctionnement des moyens d'accès.

Caractérisé en ce que les moyens d'accès sont constitués par au moins une feuille conductrice percée d'ouvertures, à laquelle sont appliquées lesdites impulsions de courant à double polarité.

Il est à noter qu'il est connu du document Wo/79/00360 de réaliser des registres à décalage à bulles magnétiques en superposant à la couche magnétique contenant les bulles une feuille conductrice percée d'ouvertures, lesdites ouvertures coopérant avec des motifs réalisés par implantation ionique dans la couche magnétique, le déplacement des bulles étant assuré par des impulsions de courant à double polarité appliquées à ladite couche conductrice.

Selon un premier mode de réalisation, les moyens d'accès comprennent deux feuilles conductrices isolées l'une de l'autre et comportant des ouvertures respectives décalées, reliées à deux sources d'impulsions de courant à double polarité délivrant des impulsions entrelacées déphasées de 90°.

Selon un second mode de réalisation, les moyens d'accès comprennent une feuille d'accès percée d'ouvertures, coopérant avec des motifs réalisés par implantation ionique, reliée à une source d'impulsions de courant à double polarité.

Les caractéristiques et avantages de l'invention ressortiront mieux de la description qui va suivre donnée en référence aux figures annexées dans lesquelles:

– la fig. 1 représente un premier mode de réalisation d'une mémoire à bulles magnétiques conforme à l'invention,

– la fig. 2 représente un autre mode de réalisation d'une mémoire à bulles conforme à l'invention.

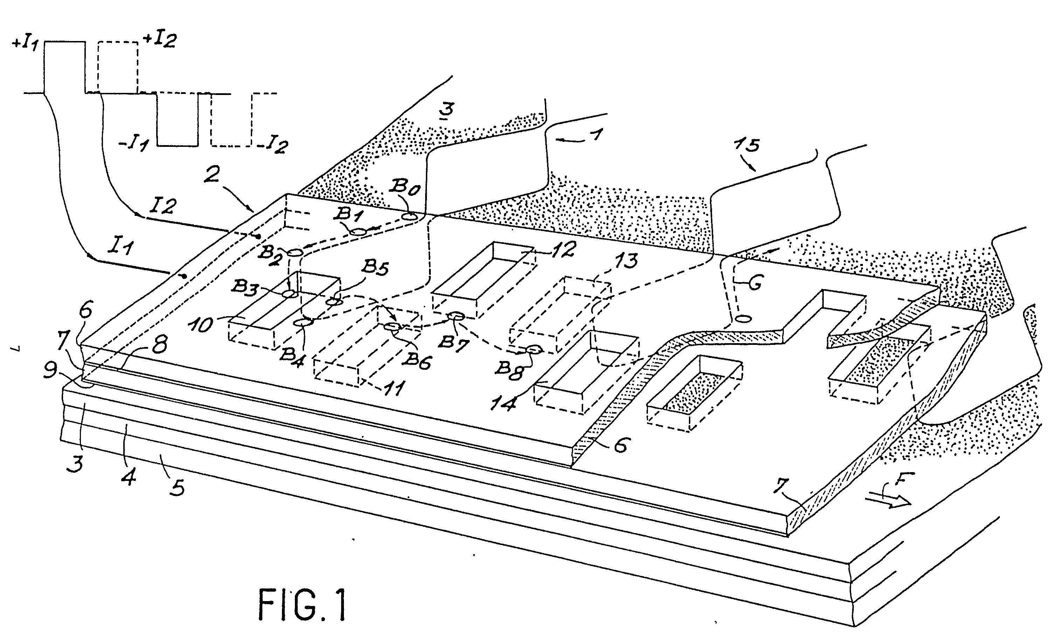

La fig. 1 représente schématiquement un premier mode de réalistion d'une mémoire à bulles magnétiques conforme à l'invention. Cette mémoire comprend une série de registres à décalage 1, orientés longitudinalement et au moins un contour d'accès 2, à ces regisres. Elle comprend également des moyens (non représentés et connus), pour produire un décalage des bulles dans les registres 1, par application d'un champ magnétique tournant. Ces moyens connus peuvent être constitués par des bobines disposées en quadrature et tournant à fréquence constante. Ce champ tournant peut être supprimé et rétabli, sans perturber l'information, de façon à ne pas être obligé d'alimenter la mémoire alors qu'elle ne fonctionne pas. Bien entendu, cette mémoire comprend aussi des moyens (non représentés et connus), qui permettent de créer les bulles dans les registres à décalage. Ces bulles sont créées, selon les besoins, par exemple au moyen d'un conducteur produisant un champ opposé au champ de polarisation. Les registres longitudinaux 1 sont constitués par des motifs qui présentent approximativement la forme de losanges sur la figure, mais qui pourraient avoir une autre forme et qui sont définis par implantation ionique dans une couche 3 d'un grenat magnétique de formule Gd YTmGalG par exemple. Cette implantation ionique est obtenue par masquage et par bombardement d'ions He+ par exemple. L'implantation ionique est réalisée à l'extérieur des losanges représentés sur la figure et les bulles sont formées et circulent en suivant le contour extérieur des losanges, dans une couche 4 d'un grenat magnétique qui peut être qualifiée de couche d'enregistrement et qui peut être constituée par exemple dans un matériau de formule EuYTm GalG. A titre d'exemple, la couche 3 qui contient les motifs implantés présente une épaisseur de 4 $\mu$, tandis que la couche 4 dans laquelle sont formées les bulles présente une épaisseur de 1 $\mu$. Enfin, et de manière connue, les deux couches précédentes sont supportées par un substrat amagnétique de formule $Gd_3 Ga_5 O_{12}$ par exemple. Selon l'invention, les motifs définis par implantation ionique et qui sont disposés longitudinalement, présentent à chacun de leurs extrémités d'accès un seul point d'accès au contour d'accès transversal 2, de sorte que l'accès à chaque registre à décalage se fasse bulle par bulle. Dans le mode de réalisation représenté sur la figure, les bulles circulent à l'extérieur des motifs et, pour une rotation complète du champ magnétique tournant, une bulle qui est située dans la position $B_0$ par exemple, occupera successivement les positions $B_1$, $B_2$, $B_3$, $B_4$, pour chaque quart de tour du champ tournant appliqué. Dans l'exemple décrit, la bulle qui occupe la position $B_4$ peut être prise en compte par le contour d'accès 2. On voit bien sur cette figure, que l'accès à chacun des registres se fait bulle par bulle. Selon l'invention, ce contour d'accès comprend des moyens d'accès par courant électrique qui seront décrits plus loin en détail, et de moyens (non représentés) qui permettent d'arrêter les moyens d'application du champ magnétique tournant au registre à décalage, pendant le fonctionnement des moyens d'accès. Dans ce premier mode de réalisation de la mémoire conforme à l'invention, les moyens d'accès par courant électrique comprennent deux feuilles conductrices superposées 6, 7, à la couche de grenat magnétique 3, situées à proximité d'accès des registres à décalage 1. Ces feuilles sont isolées entre elles et isolées du grenat magnétique 3 par des couches 8, 9 d'oxyde de silicium par exemple. Elles sont percées d'ouvertures 10, 11, 12, 13, 14, ... disposées de manière qu'au moins l'une des feuilles telle que la feuille 6 par exemple, présente des ouvertures 10, en regard respectivement, des extrémités d'accès des registres 1. Les autres ouvertures telles que 11, 12, 13, sont disposées de manière à acheminer les bulles ainsi accédées dans chacun des registres, vers une station d'accès (non représentée) ou vers un autre registre tel que le registre 15 par exemple, de la série de registres longitudinaux. Le déplacement des bulles grâce aux deux feuilles conductrices munies d'ouvertures, est réalisé en reliant ces feuilles à des sources électriques (non représentées) qui fournissent des impulsions de courant à double polarité. Ces impulsions sont représentées en $I_1$ et $I_2$ sur la figure et présentent successivement et respectivement des amplitudes $+I_1$, $+I_2$, $-I_1$, $-I_2$. Lorsqu'une bulle est parvenue dans l'un des registres, 1 par exemple, à la position $B_4$, le champ tournant est arrêté et l'impulsion $+I_1$ est appliquée à la feuille conductrice 6. Cette impulsion provoque, de manière connue, de part et d'autre de l'ouverture 10, l'apparition de pôles positifs et négatifs, de sorte que la bulle est attirée vers le pôle positif, dans la position $B_5$. Une impulsion $+I_2$ est alors appliquée à la feuille conductrice 7, de sorte que des pôles positifs et négatifs apparaissent de part et d'autre de l'ouverture 11 réalisée dans cette feuille conductrice. La bulle est alors attirée dans la position $B_6$. On applique ensuite à la feuille conductrice 6, une impulsion négative $-I_1$, qui provoque l'apparition de pôles positifs et négatifs de part et d'autre de l'ouverture 12, tel que représenté sur la figure; la bulle est alors attirée dans la position $B_7$. On applique ensuite une impulsion $-I_2$ à la feuille conductrice 7, de sorte qu'il apparaît des pôles positifs et négatifs, tels que représenté sur la figure, de part et d'autre de l'ouverture 13 de cette feuille. La bulle est alors attirée dans la position $B_8$. La bulle à laquelle on a eu accès dans la position $B_4$ peut ainsi être acheminée dans le sens de la flèche F vers une station d'accès (non représentée), par applications successives des impulsions $I_1$ et $I_2$ décrites précédemment. On peut également, au moment où la bulle est située en regard de l'ouverture 14, arrêter l'application d'impulsions aux feuilles conductrices 6, 7, et appliquer de nouveau le champ tournant de manière à faire circuler cette bulle par décalage successifs, dans le registre 15 jusqu'à une position prédéterminée, selon le parcours représenté par la flèche G.

Les parcours des bulles dans les registres longitudinaux et dans le contour d'accès, présentent un seul point commun correspondant à la position stable d'une bulle à l'extrémité de chaque registre.

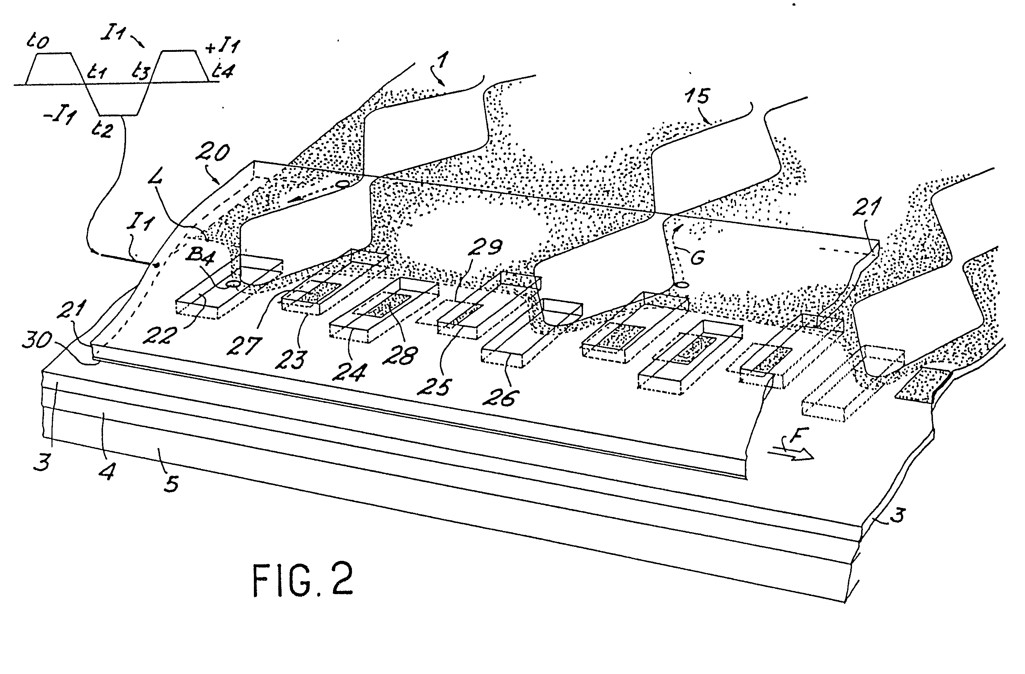

La fig. 2 représente schématiquement un autre mode de réalisation d'une mémoire à bulles conforme à l'invention. Les mêmes éléments portent les mêmes références sur cette figure et sur la fig. 1. On retrouve, comme dans le premier mode de réalisation, les registres à décalage 1, 15, etc. ... orientés longitudinalement et constitués par des motifs définis par implantation ionique dans une couche de grenat magnétique 3, superposée à une couche de grenat magnétique 4 dans laquelle les bulles sont formées; on retrouve également sur cette figure la couche support 5 des deux couches précédentes. Selon cet autre mode de réalisation, le contour d'accès désigné ici par la référence 20, comprend au moins des moyens d'accès par courant électrique constitués par la feuille conductrice 21 percée d'ouvertures 22, 23, 24, 25, 26, ...; cette feuille conductrice est superposée à la couche 3 de grenat magnétique qui contient les motifs définis par l'implantation ionique; la feuille conductrice est séparée de la couche 4 par une couche isolante 30. Dans ce mode de réalisation de la mémoire conforme à l'invention, la feuille conductrice est associée à des motifs 24, 28, 29 ... définis par implantation ionique dans la couche de grenat magnétique 3. Certaines des ouvertures telles que 22 et 26, réalisées dans la feuille conductrice 21, sont situées à proximité des extrémités d'accès des registres 1, 15, tandis que les autres ouvertures telles que 23, 24, 25, coopèrent avec les motifs 27, 28, 29 définis par implantation ionique, de manière à acheminer chaque bulle recueillie à l'extrémité d'un registre, soit vers une station d'accès (non représentée) dans le sens de la flèche F, soit vers un autre registre tel que le registre 15, dans le sens de la flèche G. Dans l'exemple de réalisation décrit, la bulle considérée est celle qui est recueillie dans la position $B_4$, à l'extrémité du registre 1. Le parcours des bulles dans le contour d'accès 20 s'effectue de la manière suivante: la feuille conductrice 21 est reliée à une source électrique de courant (non représentée) appliquant à cette feuille des impulsions de courant $I_1$ à double polarité. Lorsque la bulle se trouve dans la position $B_4$ à l'extrémité du registre 1, le champ tournant est arrêté; la bulle est alors attirée dans l'ouverture 22 grâce à l'apparition de pôles positifs et négatifs créés de part et d'autre de l'ouverture 22, grâce à l'impulsion de courant $+I_1$, dans la feuille conductrice 21. A l'instant $t_1$, le courant dans la feuille conductrice est nul et la bulle se trouve en regard du motif 27. A l'instant $t_2$, une impulsion négative $-I_1$ est appliquée à la feuille conductrice 21, des pôles positifs et négatifs apparaissant de part et d'autre de l'ouverture 23, qui attire alors la bulle. A l'instant $t_3$, la bulle se trouve en regard du motif 28, tandis qu'à l'instant $t_4$, l'application d'une impulsion positive $+I_1$ à la feuille conductrice 21, provoque l'apparition de pôles positifs et négatifs de part et d'autre de l'ouverture 24 et la bulle est attirée dans l'ouverture 24. Le processus se reproduit alors de manière identique, de manière que la bulle soit dirigée vers une station d'accès (non représentée) dans le sens de la flèche F ou vers un autre registre de la série de registres à décalage, tels que le registre 15 par exemple, dans le sens de la flèche G. En effet, lorsque la bulle parvient dans l'ouverture 26, il est possible d'appliquer à nouveau le champ magnétique tournant, aux registres à décalage, de manière que la bulle circule en sens inverse dans le registre 15 par exemple. Sur cette figure, on a représenté en L la limite de la zone implantée formant les registres.

La mémoire qui vient d'être décrite présente un contour d'accès de faible résistance (inférieure à 50 ohms) alors que dans les mémoires à bulles connues, cette résistance est de l'ordre de 1500 Ohms, ce qui provoque une dissipation thermique importante. Les tensions de commande de la mémoire conforme à l'invention sont vingt fois plus faibles que dans les mémoires connues; la taille de cette mémoire peut être réduite de 10 à 100 fois pour une même capacité d'enregistrement. De plus, le débit est grandement amélioré par rapport aux mémoires connues puisque les informations peuvent être transférées à une fréquence de 2 MHz, alors que dans les mémoires connues, cette fréquence est de 200 KHz environ. Enfin, la technologie de la mémoire conforme à l'invention est une technologie plane, grâce à la suppression des portes de transfert.

L'invention pourrait aussi être mise en œuvre si les couches 3 (couche qui contient les motifs implantés) et 4 (couche où sont formées les bulles) étaient confondues.

## Revendications

1. Mémoire à bulles magnétiques comprenant une série de registres à décalage (1) orientés longitudinalement et au moins un registre (2) orienté transversalement constitué de points mémoires desdits registres à décalage et qualifié de contour d'accès, des moyens pour produire un décalage de bulles dans les registres longitudinaux (1), par application d'un champ magnétique tournant, les registres longitudinaux (1) étant constitués par des motifs définis par implantation ionique dans une couche (4) d'un grenat magnétique et le contour d'accès transversal présentant à chaque extrémité d'accès de chacun des registres un seul point d'accès, le contour d'accès (2) comprenant des moyens d'accès par courant électrique, le parcours des bulles provoqué par ces moyens d'accès étant commandé par des impulsions ($I_1$, $I_2$) de courant de double polarité, la mémoire comprenant en outre des moyens pour arrêter les moyens d'application du champ magnétique tournant, pendant le fonctionnement des moyens d'accès, caractérisé en ce que les moyens d'accès sont constitués par au moins une feuille conductrice percée d'ouvertures, à laquelle sont appliquées lesdites impulsions de courant à double polarité.

2. Mémoire, selon la revendication 1, caractérisée en ce que les moyens d'accès comprennent deux feuilles conductrices (6, 7) isolées l'une de l'autre et comportant des ouvertures (10, 11, ..., 14, ...) respectives décalées, reliées à deux sources d'impulsions de courant à double polarité délivrant des impulsions entrelacées déphasées de 90°.

3. Mémoire, selon la revendication 1, caractérisée en ce que les moyens d'accès comprennent une feuille d'accès (21) percée d'ouvertures, coopérant avec des motifs réalisés par implantation ionique, reliée à une source d'impulsions de courant à double polarité.

## Patentansprüche

1. Magnetischer Blasenspeicher mit einer Reihe von Schieberegistern (1), die in Längsrichtung angeordnet sind, und wenigstens einem Register (2), welches quer angeordnet ist und von den Speicherpunkten der Schieberegister gebildet ist und eine Zugriffsaussenlinie aufweist, Mitteln, um eine Verschiebung der Blasen in den Längsregistern (1) durch Anlegen eines magnetischen Drehfeldes zu erzeugen, wobei die Längsregister (1) von Bereichen gebildet sind, die durch Ionenimplantation von magnetischem Granat in einer Schicht (4) festgelegt sind, und die querverlaufende Zugriffsaussenlinie an jedem Zugriffsende eines jeden Registers einen einzigen Zugriffspunkt aufweist, die Zugriffsaussenlinie (2) Zugriffsmittel durch elektrischen Strom umfasst, der durch diese Zugriffsmittel bewirkte Weg der Blasen von Stromimpulsen ($I_1$, $I_2$) mit doppelter Polarität gesteuert wird, der Speicher ferner Mittel umfasst, um die Mittel zum Anlegen eines magnetischen Drehfeldes während des Betriebes der Zugriffsmittel anzuhalten, dadurch gekennzeichnet, dass die Zugriffsmittel von wenigstens einer mit Öffnungen durchbrochenen, leitenden Folie gebildet sind, an die die Stromimpulse mit doppelter Polarität anzulegen sind.

2. Speicher nach Anspruch 1, dadurch gekennzeichnet, dass die Zugriffsmittel zwei leitende Folien (6, 7) umfassen, die voneinander isoliert sind und versetzte Öffnungen (10, 11, ..., 14, ...) aufweisen und mit zwei Stromimpulsquellen doppelter Polarität verbunden sind, die um 90 Grad phasenverschobene, verschachtelte Impulse liefern.

3. Speicher nach Anspruch 1, dadurch gekennzeichnet, dass die Zugriffsmittel eine mit Öffnungen durchbrochene Zugriffsfolie (21) umfassen, die mit den durch Ionenimplantation hergestellten Bereichen zusammenarbeitet und mit einer Stromimpulsquelle mit doppelter Polarität verbunden ist.

## Claims

1. Magnetic bubble memory comprising a series of longitudinally-oriented shift registers (1) and at least one transversely-oriented register (2) constituted by memory points of said shift registers and terminated by an access face, means for producing a shift of bubbles in the longitudinal registers (1) by application of a rotating magnetic field, the longitudinal registers (1) comprising patterns defined by ion-implantation in a layer (4) of magnetic garnet, and the transverse access face having a single point of access at each end of each register, the access face (2) comprising electric current access means, the transport of bubbles produced by said access means being commanded by bipolar current pulses ($I_1$, $I_2$), the memory additionally comprising means for interrupting application of the rotating magnetic field during functioning of the access means, characterized in that the access means comprise at least one conductive foil having openings therein, to which the said bipolar current pulses are applied.

2. Memory according to Claim 1, characterized in that the access means comprise two conductive foils (6, 7), insulated from one another and having mutually staggered openings (10, 11, ..., 14, ...), connected to two sources of bipolar current pulses delivering interdigitated pulses that are 90° out of phase with one another.

3. Memory according to Calim 1, characterized in that the access means comprise one conductive foil (21) having openings therein, cooperating with patterns formed by ion-implantation, connected to one source of bipolar current pulses.

FIG.1

FIG. 2